(19) Europäisches Patentamt
European Patent Office
Office européen des brevets

(11) Publication number: **0 011 918**
**B1**

(12) **EUROPEAN PATENT SPECIFICATION**

(45) Date of publication of patent specification: **07.03.84**

(51) Int. Cl.³: **G 03 C 1/68**

(21) Application number: **79302226.0**

(22) Date of filing: **16.10.79**

(54) **Polymerisable compositions, derived coatings and other polymerised products.**

(30) Priority: **27.10.78 GB 4223478**

(43) Date of publication of application:
**11.06.80 Bulletin 80/12**

(45) Publication of the grant of the patent:
**07.03.84 Bulletin 84/10**

(84) Designated Contracting States:
**AT BE CH DE FR GB IT LU NL SE**

(56) References cited:
**FR - A - 2 285 423**
**FR - A - 2 322 653**
**FR - A - 2 322 897**
**US - A - 3 926 639**

**S.P. Pappas, UV Curing Science and Technology, Technology Marketing Corporation (1978) pages 2 and 19**

(73) Proprietor: **IMPERIAL CHEMICAL INDUSTRIES PLC**
**Imperial Chemical House Millbank**
**London SW1P 3JF (GB)**

(72) Inventor: **McGuiness, Robert Clayton**
**Am Lohbusch 2**
**D-4006 Erkrath 1 (DE)**
Inventor: **Ledwith, Anthony**
**193 Wigan Road**
**Standish Wigan Lancashire (GB)**

(74) Representative: **Kerr, Michael Arthur et al,**
**Imperial Chemical Industries PLC Legal**
**Department : Patents Po Box 6**
**Welwyn Garden City Herts, AL7 1HD (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 011 918 B1

# Polymerisable compositions, derived coatings and other polymerised products.

This invention relates to photopolymerisable compositions, to coatings and to other products obtained by polymerisation of the photopolymerisable compositions.

In our British Patent 1,526,923 we have described and claimed *inter alia* a photopolymerisable composition comprising at least one acid-polymerisable or acid-curable material and as photosensitiser at least one salt of formula

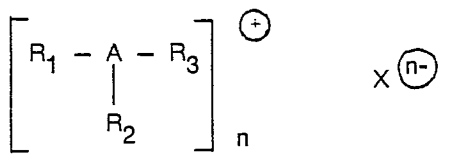

wherein A is sulphur, selenium or tellurium, n is 1 or 2, $R_1$, $R_2$ and $R_3$, which may be the same or different, each is a hydrocarbon or substituted hydrocarbon group or heterocyclic group or two of the groups $R_1$, $R_2$ and $R_3$ together with the element A are a heterocyclic structure the other group R being a hydrocarbon or a substituted hydrocarbon group, and $X^{n-}$ is an anion derived from an acid which is capable of polymerising or curing the acid-polymerisable or acid-curable material. We have also described the preparation of a polymeric material by exposing the composition to radiation of a suitable wavelength.

British Patent 1,516,511 (General Electric Company) describes and claims *inter alia* a curable composition comprising (A) a monoepoxide, an epoxy resin or a mixture thereof polymerisable to a higher molecular weight state, and (B) a radiation sensitive aromatic onium salt of O, S, Se, or Te in an amount capable of effecting the cure of (A) by release of a Lewis catalyst when exposed to radiant energy; and British Patent 1,518,141 (General Electric Company) describes and claims *inter alia* a polymerisable composition comprising (A) a monomeric or prepolymeric cationically polymerisable organic material free of oxirane oxygen selected from vinyl monomers, vinyl prepolymers, cyclic ethers, cyclic esters, cyclic sulfides, cyclic amines and organosilicon cyclics, and (B) an effective amount of a radiation sensitive aromatic onium salt of sulphur, selenium or tellurium capable of effecting the polymerisation of (A) by release of a Lewis Acid catalyst when exposed to radiant energy.

U.S. Patent 4,069,054 (Minnesota Mining and Manufacturing Company) describes and claims *inter alia* a photopolymerisable composition comprising: (a) a cationically polymerisable monomer

(b) an aromatic sulphonium compound of formula:

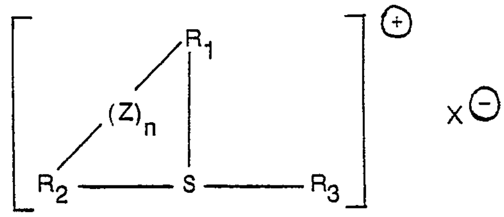

wherein $R_1$, $R_2$ and $R_3$ are selected from the group consisting of aryl groups having 4 to 20 carbon atoms and alkyl radicals having 1 to 20 carbon atoms; wherein at least one of $R_1$, $R_2$ and $R_3$ is aryl; wherein Z is selected from the group consisting of oxygen; sulphur;

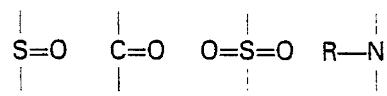

where R is aryl or acyl; a carbon-carbon bond; or

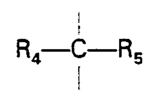

where $R_4$ and $R_5$ are selected from the group consisting of hydrogen, an alkyl radical having 1—4 carbon atoms, and an alkenyl radical having 2—4 carbon atoms; and n is zero or 1; and X- is a halogen-containing complex anion selected from tetrafluoroborate, hexafluorophosphate, hexafluoroarsenate, and hexafluoroantimonate; and (c) a sensitising compound selected from the group consisting of

(i) aromatic tertiary amines having the formula

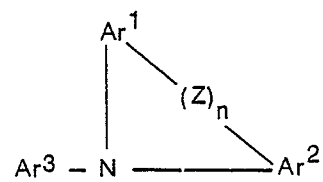

where $Ar^1$, $Ar^2$ and $Ar^3$ are groups having 6—20 carbon atoms; Z is selected from oxygen, sulfur;

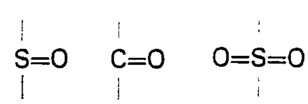

a carbon-carbon bond; or

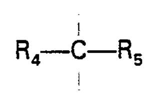

where $R_4$ and $R_5$ are selected from hydrogen, alkyl radicals of 1—4 carbon atoms, and alkenyl radicals of 2—4 carbon atoms, and wherein n is zero or 1;

(ii) aromatic tertiary diamines having the formula

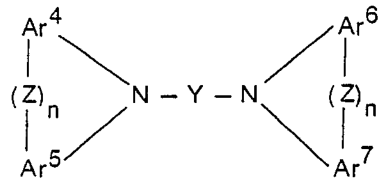

where Y is a divalent radical selected from arylene and $Ar^8$—Z—$Ar^9$, where Z is as described above, $Ar^4$, $Ar^5$, $Ar^6$, $Ar^7$, $Ar^8$ and $Ar^9$ are aryl groups having 6—20 carbon atoms; and wherein n and m are zero or 1; and

(iii) aryl polycyclic compounds having at least three fused benzene rings and further having an ionisation energy less than about 7.5 eV.

U.S. Patent 4,069,054 refers to the above-mentioned materials as only select materials which are useful in sensitising aromatic sulphonium salts.

In a review article by J.V. Crivello entitled "Photoinitiated Cationic Polymerisation" (see page 63 of "UV Curing: Science & Technology", 1978, published by Technology Marketing Corporation and edited by P. Pappas.) it is stated that diaryliodonium and triarylsulphonium salts show certain parallel behaviour with respect to their photochemical properties. In particular it is stated that their photolysis is not accelerated by radical initiators.

Therefore it is surprising that we have now found that the rate of polymerisation of materials polymerisable by an acid catalysed mechanism in the presence of aromatic sulphonium salts may be increased and in many cases the wavelength spectrum of sensitivity of the salts may be extended towards the visible region when there is present in a photopolymerisable composition of general type described in British Patent Specifications 1,526,923; 1,516,511; and 1,518,141, a photosensitive aromatic sulphonium salt and a material which under the conditions of photopolymerisation, by itself or by hydrogen abstraction with a component of the composition other than the sulphonium salt, will yield free radicals. This finding is of particular importance with regard to the formulation of photopolymerisable compositions in which there is present a component which plays no part in the photopolymerisation process but which absorbs radiation in that same region of the wavelength spectrum which is required for activation of the sulphonium salt. Such components include for example pigments particularly titanium dioxide which absorbs radiation substantially in the ultraviolet region.

According to this invention we provide a photopolymerisable composition capable of polymerisation by an acid-catalysed mechanism under the influence of ultraviolet and/or visible light which comprises the components:

(a) at least one material capable of polymerisation by an acid catalysed mechanism to a polymeric material of higher molecular weight state;

(b) a photosensitive aromatic sulphonium salt which is represented by the formula:

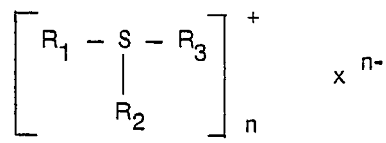

wherein n is 1 or 2; $R_1$, $R_2$ and $R_3$, which may be the same or different, each is a hydrocarbon or substituted hydrocarbon group or heterocyclic group or two of the groups $R_1$, $R_2$ and $R_3$ together with the S atom are a heterocyclic structure, the other group R being a hydrocarbon group or substituted hydrocarbon group, at least one group R attached to the S atom being an aromatic group; $X^{n-}$ is an anion derived from an acid which is capable of polymerising the material (a) of the composition by an acid-catalysed mechanism to a higher molecular weight state, characterised in that it additionally contains:

(c) a conventional free radical generator which under the influence of ultra-violet and/or visible light generates a significant proportion of free radicals which are readily converted to the corresponding carbocation by the sulphonium salt either (i) by intramolecular cleavage, or (ii) by intermolecular abstraction in conjunction with a component of the composition other than the photosensitive aromatic sulphonium salt.

Within the term "polymerisation by an acid-catalysed mechanism" we include polymerisation by an acid-catalysed cationic addition mechanism and polymerisation by an acid-catalysed condensation mechanism.

Preferably the photopolymerisable composition contains a further component (d) which plays no direct part in the photopolymerisation process but which, when the composition is irradiated to cause polymerisation absorbs at least some of that irradiation to which the sulphonium salt is sensitive. Suitable such materials include, for example, pigments and other additives which may be used for example in the formulation of paints, other surface coatings and other polymerised products. A particularly appropriate pigment is titanium dioxide.

The definition of component (c) does not embrace the sensitising compounds mentioned in U.S. Patent No. 4,069,054. It is believed that these compounds behave in a manner significantly different from the behaviour of the materials (c) which yield free radicals.

For the formulation of a fully effective photopolymerisable composition, component (c) is preferably of good solubility in the material (a)

to be polymerised. We have found that the solubility of (c) in acetone is a useful general guide to the solubility of (c) in (a) and that preferred components (c) can be usefully selected on this basis. Thus it is preferred that component (c) has a solubility in acetone which is greater than 2% by weight of (c) based on the volume of acetone.

It is also preferred that the component (c) of the photopolymerisable composition is one which does not yield a coloured product when irradiated in the presence of the sulphonium salt. Since the present compositions find important application as coatings in which colour or lack of colour must be closely controlled it is clearly important that the light induced products of interaction between the polymerisable material, the sulphonium salt and component (c) are not intensely coloured and preferably they are substantially free from colour. Thus unsuitable materials as component (c) include certain amines and sulphur compounds.

Suitable materials as component (c) which yield a significant proportion of free radicals useful in the present invention under the conditions of polymerisation to be employed can be determined by reference to the following papers: A. Ledwith, Pure and Applied Chem., *49* 431—441 (1977); Hutchinson & Ledwith, Adv. Polymer Science, *14,* 49 (1974); and to "Free Radicals", Volumes I and II, by J.K. Kochi (Wiley 1973). Thus it is preferred to employ as component (c) conventional free radical generators which generate a significant proportion of free radicals and such as are disclosed in these references.

Different materials (c) will in many cases yield free radicals under different conditions of irradiation and clearly in practising this invention one will normally choose that material which provides free radicals to the optimum extent under any chosen irradiation conditions. The irradiation may be desired in the ultraviolet and/or in the visible part of the spectrum for example at a wavelength in the range about 200—380 nm for ultraviolet and in the range 380—700 nm for the visible. It is a particular advantage of this invention that in many cases photopolymerisable compositions may be polymerised when irradiated with visible light, i.e. in the range 380—700 nm.

Particularly suitable materials as component (c) are those which on irradiation yield free radicals which are readily converted to the corresponding carbocations by the sulphonium salt. The free radical to be oxidised may be that resulting from cleavage, hydrogen abstraction, or by any other suitable radical-forming mechanism.

Particularly suitable types of material which may be used as component (c) (i) of the photopolymerisable compositions include benzoin; the benzoin alkyl ethers, for example benzoin methyl ether and benzoin ethyl ether; derivatives of acetophenone, for example alkoxy aryl acetophenones such as 2,2-dimethoxy-2-phenyl-acetophenone and 2,2-diethoxyacetophenone, and 1-phenyl-1, 2-propanedione-2-O-benzoyl oxime; and halogenated acetophenones such as 2,2-dichloroacetophenone.

Particularly suitable types of material which may be used as component (c) (ii) include aromatic diketones, for example 9,10-phenanthrenequinone; 9-10-anthraquinone and benzil, and derivatives of these ketones; benzophenone and its derivatives; compounds capable of diradical formation such as O-methyl acetophenone, materials of structure

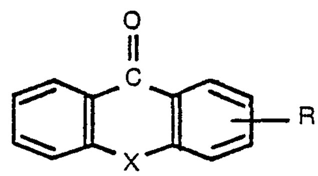

wherein X=O, S, $CH_2$ or a direct carbon-carbon bond, i.e. xanthone, thioxanthone, anthrone and fluorenone respectively (when R = H) and derivatives of such materials for example where R = halogen, alkyl or substituted alkyl, i.e. derivatives such as 2-isopropylthioxanthone and 2-methylthioxanthone; and certain aromatic aldehydes such as piperonal of structure

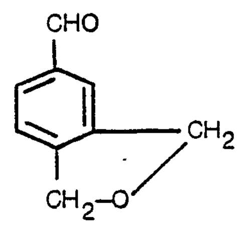

and derivatives thereof; and many halogenated materials such as the arylchloromethyl and arylchlorosulphonyl derivatives which are referred to in Table II at page 19 of the book mentioned above edited by P. Pappas.

In the case of components (c) (ii) they will normally abstract hydrogen from a hydrogen-donor which is present in the photopolymerisable composition and this will commonly be the material which is to be polymerised. However other suitable components of a photopolymerisable composition which may act as hydrogen-donor include tetrahydrofuran, hydrocarbons and ethers or even the component (c) (ii) itself.

Unsuitable materials as component (c) (ii) include those which contain groups reactive with organic carbocations e.g. certain amines and sulphur compounds. Examples of such unsuitable types are 4,4′-dimethylaminobenzophenone (Michlers Ketone) and 4,4′-diethylaminobenzophenone.

The amount of material (c) is not usually critical but will usually be from 0.01% to 10% and preferably from 0.05% to 5% by weight

based on the weight of polymerisable material in the composition. The optimum amount will usually be about 0.5—3% by weight.

The groups R in the aromatic sulphonium salt may be, for example, alkyl, cycloalkyl, aryl, alkaryl, or aralkyl groups or substituted derivatives thereof, and substituted or unsubstituted heterocyclic groups such as pyridyl or furfuryl. Preferably each of the groups R is an aryl or substituted aryl group or one of such groups may be an alkyl or substituted alkyl group. Examples of substituents which may be present in the groups R are halogen, alkoxy, —COOR, —COR, $—NO_2$, —NO or —OH.

Particularly suitable substituents are those which extend the absorption of the sulphonium compound towards the visible region e.g. nitro groups.

The anion $X^{(n-)}$ may be for example a halogen-containing complex ion. The complex ion may be a halogenide of a metal or metalloid element, for example a polyhalide of boron, antimony, phosphorous, tin, bismuth, arsenic or iron. Examples of suitable anions are $BF_4^-$, $SbCl_6^-$, $SbF_6^-$, $SnCl_6^{--}$, $PF_6^-$, $AsF_6^-$, $FeCl_4^-$, $BiCl_5^{--}$, or $R_5SO_3$, where $R_5$ is an aromatic hydrocarbon radical having 6—13 carbon atoms, an alkyl radical having 1—8 carbon atoms, halogenated derivatives thereof or $R_5$ is fluorine; or $ClO_4^-$, or $CF_3$ $COO^-$, or $ArSO_3^-$, or $HSO_4$, or $NO_3^-$ or the picrate ion.

Particularly suitable sulphonium salts include those which are disclosed in our British Patent 1,526,925.

The ability of a particular sulphonium salt to yield fragments capable of polymerising a particular material (a) reflects the ability of the corresponding proton acid, i.e. the proton acid containing the same anion as the salt, to polymerise that material. If the proton acid polymerises the material, then the sulphonium salt containing the same anion also will be capable of providing fragments which will polymerise the material. Thus the suitability of a particular salt for use with a particular polymerisable material is readily determined simply by mixing the corresponding proton acid with the material.

The sulphonium salts used in this invention are normally solids at ordinary temperatures and they are usually incorporated in the polymerisable material (a) in the form of a solution in some suitable liquid. Any inert liquid diluent in which the salt is sufficiently soluble may be used, and example of suitable diluents are halogenated hydrocarbons, e.g. methylene chloride, ketones, e.g. acetone. We prefer to employ a liquid diluent of low boiling point, e.g. below 150°C in order to facilitate removal of the diluent from the composition. The amount of the diluent used is not critical but preferably is just sufficient to dissolve the appropriate amount of the sulphonium salt. After incorporation of the salt in the composition, the diluent may be removed, if desired, before the composition is irradiated. Removal of the diluent prior to irradiating the composition, may be desirable in cases where the diluent is a solvent for the polymerisable material. In the case where the material is, or contains, a monomer, the salt may be soluble in the material and a diluent may not be required.

The amount of the sulphonium salt is not critical but will usually be from 0.01% to 10.0%, and preferably from 0.5% to 5.0% by weight based on the weight of polymerisable material in the composition. In general increasing the amount of the sulphonium salt results in an increase in the rate of polymerisation or curing achieved although in practice there is little point in using an amount of greater than 10% by weight.

The sulphonium salt preferably should be soluble in the polymerisable material (a) into which it is incorporated and the solubility of a particular salt in the material may limit the amount of that salt which can be incorporated. The polymerisation reaction initiated by irradiating the composition is exothermic and use of too large an amount of the sulphonium salt may result in a very rapid rise in temperature and loss of control over the reaction conditions. The optimum amount of the sulphonium salt will usually be about 3% to 5% by weight but will depend upon the particular salt and polymerisable material employed and the radiation source, and can be determined by simple experiment.

In general, polymerisation or curing of the composition proceeds readily when the composition is irradiated at ambient temperature although the reaction is exothermic and may be accompanied by a rise in temperature of the composition. The rate of polymerisation or curing in general may be increased by irradiating the composition at an elevated temperature.

The present invention thus provides a method of producing a polymeric composition which consists in irradiating with ultraviolet and/or visible light a photopolymerisable composition as described above. The invention also provides a polymeric composition when produced by this method.

Particularly useful photopolymerisable compositions according to the invention are those which are to be applied as coating to surfaces and which are preferably pigmented. Compositions comprising combinations of components (b) and (c), which together effect polymerisation on irradiation by near ultraviolet and/or visible light, is less affected by the absorption of ultraviolet light by certain pigments, (notably titanium dioxide) which may be contained in the composition, compared with compositions free from (c).

The photopolymerisable material (a) capable of polymerisation by an acid-catalysed mechanism to a polymeric material of a higher molecular weight state is of very wide scope.

Clearly the choice of such material will be limited to an extent which depends upon the nature of the aromatic sulphonium salt (b) and on the nature of the material (c) and also upon the nature of the ultraviolet and/or visible light with which the photopolymerisable material is irradiated. As already stated it is one advantage of the compositions of the present invention that they may be sensitive to, and hence can be polymerised on irradiation with, visible light.

The term "polymerisable material" also includes curable materials, for example materials which are already of high molecular weight and which are cross-linked by the process of the present invention. Mixtures of polymerisable or curable materials (a) may be employed, as also may mixtures of one or more polymerisable or curable materials (a) with resins which are not polymerisable by an acid-catalysed mechanism for example alkyd resins. Materials containing polymerisable cyclic groups may be employed, notably cyclic ethers for example lactones and acrolein tetramer and especially epoxides and episulphides, and polymers thereof containing polymerisable cyclic groups. Epoxides and episulphides containing from 2 to 20 carbon atoms are suitable, for example the cycloaliphatic epoxides, ethylene oxide, ethylene sulphide, propylene oxide and propylene sulphide, as also are compounds containing two or more epoxide or episulphide groups. Epoxy and episulphide resins may be used, for example the epoxy resins commonly known as Araldite epoxy resins. Other resins curable by an acid-catalysed mechanism which may be used include phenolic resins, for example phenol/formaldehyde resins, aminoplastics, for example urea/formaldehyde and melamine/formaldehyde resins, methylol compounds, methylol ethers of polycarboxylic acid amides, for example derivatives of polyacrylic and polymethacrylic acid amides, alkyd resins containing urethane groups and resins containing carbonic acid esters of N-methylolamides. Acid-polymerisable or acid-curable ethylenically unsaturated materials may also be used, for example vinyl carbazole, vinyl ethers and diketene (which is both ethylenically unsaturated and a lactone). Resinous materials containing cross-linking agents which can be cured by acids are included.

Preferably the polymerisable compositions of this invention do not contain any significant proportion of material which is polymerisable by free radicals, for example radical-polymerisable ethylenically unsaturated materials, since it is our intention that the significant proportion of free radicals which is generated by material (c) on radiation, although capable of polymerising such materials is utilised to the fullest extent in promoting the acid-catalysed polymerisation.

The compositions of the invention may be used in any of the applications for which materials polymerisable by a cationic mechanism are normally employed, provided that, if the composition is to be polymerised or cured *in situ*, irradiation of the composition is possible. Thus the compositions may be used, for example, for forming surface coatings on a variety of substrates, e.g. wood, paper, metals and textiles, and in printing inks. They may be used as adhesives in applications where they can be subjected *in situ* to radiation, for example in the formation of laminates wherein one or both of the lamina is permeable to radiation, e.g. glass lamina and some plastic lamina. The compositions have the property that only those regions contacted by radiation are polymerised or cured so that they may be used for example in the production of decorative articles having a contoured surface by exposing parts of the surface to radiation to cure those parts and subsequently removing uncured material from the surface. Thus they may be used, for example in the production of printing plates and printed circuits.

The invention is illustrated by the following Examples in which parts and percentages are by weight unless otherwise stated:

### Example 1

A mixture containing 3 parts of triphenyl sulphonium hexafluorophosphate and 1 part of isopropylthioxanthone in 100 parts of 3,4-epoxy-cyclohexylmethyl- 3,4-epoxy-cyclohexyl carboxylate (commercially available as ERL 4221 from Union Carbide) was coated onto a glass plate to form a film of 25$\mu$m thickness. When this film was irradiated at a distance of 0.102 m using a Thorn Graph-X (Registered Trade Mark) 400w lamp (which emitted radiation in the wavelength range 330—500 nm but predominantly in the visible region) a clear, hard, teck-free coating was produced after 30 seconds. A similar mixture which did not contain isopropylthioxanthone was still tacky after 700 seconds irradiation.

When the isopropylthioxanthone was replaced by an equal weight of first benzil and they by tetracetyl robiflavin, the film was tack-free after 60 seconds in each case.

### Example 2

A mixture containing 3 parts of triphenyl sulphonium hexafluorophosphate and 100 parts of the diglycidyl ether of bisphenol A (commercially available as DER 331" from Dow Chemical) was pigmented with rutile titanium dioxide to a pigment volume concentration of 10.8% and was coated onto a glass plate to form a film of 25 $\mu$m thickness. When the film was irradiated at 6.10 m/minute beneath a 78.7 w/cm medium pressure mercury vapour lamp (providing predominantly ultraviolet radiation but also a proportion of visible radiation) 6 passes were needed to achieve a hard, tack-free coating. when there was also present 1% of isopropylthioxanthone only 4 passes were required.

Example 3

Each of a series of compositions containing 3 parts of triphenyl sulphonium fluoroborate in 100 parts of the commercially available aliphatic epoxide "ERL 4221", used in Example 1, was mixed with 1 part of one of the additives listed below and these compositions were coated onto glass as films of 12 $\mu$m thickness. The films were irradiated using a Thorn Graph-X 400w lamp emitting radiation in the wavelength range 330—500 nm but predominantly in the visible region at a distance of 0.102 m from the lamp, and the time taken for curing to a hard, tack-free coating was determined:

| Additive | Cure Time (minutes) |
|---|---|
| None | uncured after 15 |
| Benzil | 13 |
| 2,2-dimethoxy, 2-phenyl-acetophenone | 13.5 |
| 2-isopropylthioxanthone | 9.5 |
| Benzoin isopropylether | 8 |
| 2-tertbutyl anthraquinone | 10.5 |

(2-isopropylthioxanthone has a solubility in acetone of 30% w/v whereas 2-chlorothioxanthone and 2-tertbutyl anthraquinone have a solubility of less than 2% w/v.)

When only 1 part of the sulphonium salt was employed in 100 parts of the epoxide together with 1 part of 2-isopropylthioxanthone, a coating applied to glass was only partially cured after 15 minutes.

Example 4

A mixture containing 3 parts of tris-(4-methylphenyl) sulphonium hexafluorophosphate, 100 parts of "DER 331" as used in Example 2 (and which is less readily polymerised than the aliphatic epoxide ERL—4221), and 1 part of 2-isopropylthioxanthone was coated onto glass as a film (a) of thickness 12 $\mu$m. Another mixture without the 2-isopropylthioxanthone was similarly coated as a film (b) on glass. After irradiation as described in Example 3 for 13½ minutes film (a) had cured whereas film (b) remained uncured after 15 minutes. When only 0.5 parts of the 2-isopropylthioxanthone were employed, the film was not fully cured after 15 minutes of irradiation.

Example 5

Two compositions (a) and (b) each containing 3 parts of tris-(4-methylphenyl) sulphonium hexafluoroarsenate and 100 parts of the aliphatic epoxide "ERL 4221" as used in Example 1, were mixed respectively with 1 part of 2-isopropylthioxanthone and 1 part of 2,2-dimethoxy 2-phenylacetophenone. The compositions were applied to glass and irradiated as described in Example 3. Composition (a) cured in 10 seconds and composition (b) cured in 80 seconds. In the absence of either additive the composition was uncured after 80 seconds.

When the amount of sulphonium salt was reduced to 1 part and the amount of additive was reduced to 0.5 part the times of curing were increased to 20 and 170 seconds respectively. In the absence of either additive the composition was uncured after 180 seconds.

Example 6

A mixture containing 0.5 part of triphenylsulphonium hexafluoroantimonate, 100 parts of the aliphatic epoxide "ERL 4221" used in Example 1, and 2 parts of benzoin isopropyl ether was coated onto glass and irradiated as described in Example 2. The coating was cured after 4 passes whereas in the absence of the benzoin isopropyl ether a coating remained wet and uncured after 8 passes.

**Claims**

1. A photopolymerisable composition capable of polymerisation by an acid-catalysed mechanism under the influence of ultraviolet and/or visible light which comprises the components:

(a) at least one material capable of polymerisation by an acid catalysed mechanism to a polymeric material of higher molecular weight state;

(b) a photosensitive aromatic sulphonium salt which is represented by the formula:

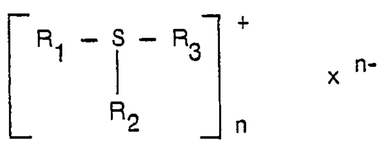

wherein n is 1 or 2; $R_1$ and $R_3$, which may be the same or different, each is a hydrocarbon or substituted hydrocarbon group or heterocyclic group or two of the groups $R_1$, $R_2$ and $R_3$ together with the S atom are a heterocyclic structure, the other group R being a hydrocarbon group or substituted hydrocarbon group, at least one group R attached to the S atom being an aromatic group; $X^{n-}$ is an anion derived from an acid which is capable of polymerising the material (a) of the composition by an acid-catalysed mechanism to a higher molecular weight state, characterised in that it additionally contains:

(c) a conventional free radical generator which under the influence of ultra-violet and/or visible light generates a significant proportion of free radicals which are readily converted to the corresponding carbocation by

the sulphonium salt either (i) by intramolecular cleavage, or (ii) by intermolecular abstraction in conjunction with a component of the composition other than the photosensitive aromatic sulphonium salt.

2. A photopolymerisable composition according to claim 1 wherein a component (c) (i) is selected from benzoin and benzoin alkyl ethers; substituted acetophenones, for example dialkoxyacetophenones, alkoxy aryl acetophenones, 1-phenyl-1, 2-propanedione-2-O-benzoyl oxime and halogenated acetophenones; or a component (c) (ii) is selected from aromatic diketones and substituted aromatic diketones, benzophenone and substituted benzophenones; materials of structure

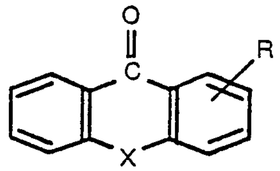

wherein X = O, S, $CH_2$ or a direct carbon-carbon bond and R = H, and substituted materials of the above structure where R = halogen, alkyl or substituted alkyl; compounds capable of diradical formation; and piperonal.

3. A photopolymerisable composition according to claim 1 or claim 2 comprising a further component (d) which plays no part in the polymerisation process but which, when the composition is irradiated with ultraviolet and/or visible light, absorbs at least some of that radiation to which the sulphonium salt is sensitive.

4. A photopolymerisable composition according to any one of claims 1—3, wherein $X^{n-}$ is selected from $BF_4^-$, $SbCl_6^-$, $SbF_6^-$, $SnCl_6^{--}$, $PF_6^-$, $AsF_6^-$, $FeCl_4^-$, $BiCl_5^{--}$, or $R_5SO_3$ where $R_5$ is an aromatic hydrocarbon radical having 6—13 carbon atoms, an alkyl radical having 1—8 carbon atoms, and halogenated derivatives thereof, or $R_5$ is fluorine.

5. A photopolymerisable composition according to any one of claims 1 to 4, wherein there is present 0.01 to 10% by weight based on the composition of the component (c).

6. A photopolymerisable composition according to any one of claims 1 to 5, wherein the material capable of polymerisation to a higher molecular weight state is selected from epoxides, episulphides, and other cyclic ethers and thioethers; epoxy resins; episulphide resins; vinyl ethers; phenolic resins; and aminoplasts.

7. A photopolymerisable coating composition according to claim 3 in which the component (d) is a pigment.

8. A polymerised composition obtained by irradiating with ultraviolet and/or visible light a composition according to any one of claims 1 to 6.

**Patentansprüche**

1. Photopolymerisierbare Zusammensetzung, die durch einen säurekatalysierten Mechanismus unter dem Einfluß von ultraviolettem und/oder sichtbarem Licht polymerisierbar ist und die die folgenden Komponenten enthält:

(a) mindestens ein Material, das durch einen säurekatalysierten Mechanismus in ein polymeres Material mit einem höheren Molekulargewicht polymerisierbar ist;

(b) ein photosensibles aromatisches Sulfoniumsalz der Formel

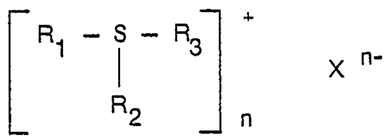

worin n für 1 oder 2 steht; $R_1$, $R_2$ und $R_3$, welche gleich oder verschieden sein können, jeweils für eine Kohlenwasserstoff- oder substituierte Kohlenwasserstoffgruppe oder eine heterocyclische Gruppe stehen oder zwei der Gruppen $R_1$, $R_2$ und $R_3$ gemeinsam mit dem S-Atom eine heterocyclische Struktur bilden, wobei die andere Gruppe R eine Kohlenwasserstoffgruppe oder substituierte Kohlenwasserstoffgruppe ist und wobei mindestens eine Gruppe R, die an das S-Atom gebunden ist, eine aromatische Gruppe ist; und $X^{n-}$ für ein Anion steht, das sich von einer Säure ableitet, welche das Material (a) der Zusammensetzung durch einen säurekatalysierten Mechanismus auf ein höheres Molekulargewicht polymerisieren kann, dadurch gekennzeichnet,

daß sie zusätzlich enthält,

(c) einen herkömmlichen Bildner von freien Radikalen, der unter dem Einfluß von ultraviolettem und/oder sichtbarem Licht eine beträchtliche Menge freier Radikale bildet, die leicht durch das Sulfoniumsalz in das entsprechende Carbokation umgewandelt werden können, und zwar (i) durch intramolekulare Spaltung oder (ii) durch intermolekulare Abspaltung im Zusammenhang mit einer anderen in der Zusammensetzung vorhandenen Komponente als dem photosensiblen aromatischen Sulfoniumsalz.

2. Photopolymerisierbare Zusammensetzung nach Anspruch 1, bei welcher eine Komponente (c) (i) ausgewählt ist aus Benzoin und Benzoinalkylethern; substituierten Acetophenonen, wie z.B. Dialkoxyacetophenonen, Alkoxyaryl-acetophenonen, 1-Phenyl-1,2-propandion-2-O-benzoyloxim und halogenierten Acetophenonen; oder eine Komponente (c) (ii) ausgewählt ist aus aromatischen Diketonen und substituierten aromatischen Diketonen; Benzophenon und substituierten Benzophenonen; Materialien der Struktur

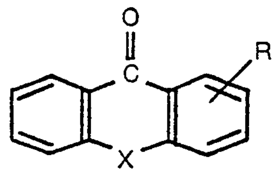

worin X = O, S, $CH_2$ oder eine direkte Kohlenstoff-Kohlenstoff-Bindung und R = H, und substituierten Materialien der obigen Struktur, worin R = Halogen, Alkyl oder substituiertes Alkyl; Verbindungen, die ein Diradikal bilden können; und Piperonal.

3. Photopolymerisierbare Zusammensetzung nach Anspruch 1 oder 2, welche eine weitere Komponente (d) enthält, die bei dem Polymerisationsprozeß keine Rolle spielt, die aber, wenn die Zusammensetzung mit ultraviolettem oder sichtbarem Licht bestrahlt wird, mindestens einen Teil der Strahlung absorbiert, gegenüber welcher das Sulfoniumsalz sensibel ist.

4. Photopolymerisierbare Zusammensetzung nach einem der Ansprüche 1 bis 3, bei welcher $X^{n-}$ ausgewählt ist aus $BF_4^-$, $SbCl_6^-$, $SbF_6^-$, $SnCl_6^{--}$, $PF_6^-$, $AsF_6^-$, $FeCl_4^-$, $BiCl_5^{--}$ oder $R_5SO_3^-$, worin $R_5$ für ein aromatisches Kohlenwasserstoffradikal mit 6—13 Kohlenstoffatomen, ein Alkylradikal mit 1—8 Kohlenstoffatomen, ein halogeniertes Derivat davon oder Fluor steht.

5. Photopolymerisierbare Zusammensetzung nach einem der Ansprüche 1 bis 4, bei welcher 0,01 bis 10 Gew.-% der Komponente (c), bezogen auf die Zusammensetzung enthalten sind.

6. Photopolymerisierbare Zusammensetzung nach einem der Ansprüche 1 bis 5, bei welcher das Material, das auf ein höheres Molekulargewicht polymerisierbar ist, ausgewählt ist aus Epoxiden, Episulfiden und anderen cyclischen Ethern und Thioethern; Epoxyharzen; Episulfidharzen; Vinylethern, Phenolharzen; und Aminoplasten.

7. Photopolymerisierbare Beschichtungszusammensetzung nach Anspruch 3, bei welcher die Komponente (d) ein Pigment ist.

8. Polymerisierte Zusammensetzung, welche durch Bestrahlung einer Zusammensetzung nach einem der Ansprüche 1 bis 6 mit ultraviolettem und/oder sichbarem Licht erhalten worden ist.

**Revendications**

1. Composition photopolymérisable susceptible de polymérisation par un mécanisme catalysé par les acides sous l'influence de la lumière ultraviolette et/ou visible, qui comprend les constituants:

(a) au moins une matière susceptible de polymérisation par un mécanisme catalysé par les acides en une matière polymère d'un état de poids moléculaire supérieur;

(b) un sel de sulfonium aromatique photosensible représenté par la formule:

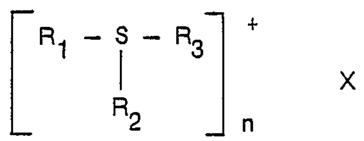

où n représente 1 ou 2, $R_1$, $R_2$ et $R_3$, qui peuvent être identiques ou différents, représentent chacun un radical hydrocarboné ou hydrocarboné substitué ou un radical hétérocyclique ou bien deux des radicaux $R_1$, $R_2$ et $R_3$ forment avec l'atome S une structure hétérocyclique, l'autre radical R étant un radical hydrocarboné ou hydrocarboné substitué, au moins un radical R uni à l'atome S étant un radical aromatique; $X^{n-}$ est un anion issu d'un acide qui est capable de polymériser la matière (a) de la composition par un mécanisme catalysé par les acides jusqu'à un état de poids moléculaire supérieur; caractérisée en ce qu'elle contient, en outre:

(c) un générateur de radicaux libres classique qui, sous l'influence de la lumière ultraviolette et/ou visible, engendre une proportion sensible de radicaux libres qui sont aisément convertis en le carbocation correspondant par le sel de sulfonium, soit (i) par scission intramoléculaire, soit (ii) par élimination intermoléculaire d'hydrogène conjointement avec un constituant de la composition autre que le sel de sulfonium aromatique photosensible.

2. Composition photopolymérisable suivant la revendication 1, dans laquelle un constituant (c) (i) est choisi parmi la benzoïne et les éthers alcoyliques de benzoïne; les acétophénones substituées, par exemple les dialcoxyacétophénones, les alcoxyarylacétophénones, la 1-phényl-1,2-propanedione-2-O-benzoyloxime et les acétophénones halogénées; ou un constituant (c) (ii) est choisi parmi les dicétones aromatiques et dicétones aromatiques substituées, les benzophénones et benzophénones substituées; les composés de formule

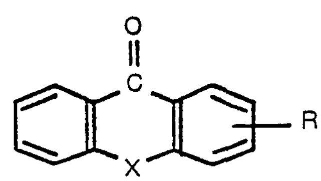

où X représente O, S, $CH_2$ ou un liaison directe carbone-carbone et R représente H, et les composés substitués de formule ci-dessus où R représente un radical halogéno, alcoyle ou alcoyle substitué; les composés susceptibles de former des diradicaux; et le pipéronal.

3. Composition photopolymérisable suivant la revendication 1 ou 2, qui comprend en outre un constituant (d) qui ne joue pas de rôle dans le processus de polymérisation, mais qui, lorsque la composition est irradiée en lumière ultraviolette et/ou visible, absorbe au moins une partie du rayonnement auquel le sel de sulfonium est sensible.

4. Composition photopolymérisable suivant

l'une quelconque des revendications 1 à 3, dans laquelle $X^{n-}$ est choisi parmi $BF_4^-$, $SbCl_6^-$, $SbF_6^-$, $SnCl_6^{--}$, $PF_6^-$, $AsF_6^-$, $FeCl_4^-$, $BiCl_5^{--}$ ou $R_5SO_3$, où $R_5$ représente un radical hydrocarboné aromatique comptant 6 à 13 atomes de carbone, un radical alcoyle comptant 1 à 8 atomes de carbone ou un de leurs dérivés halogénés, ou bien $R_5$ représente un atome de fluor.

5. Composition photopolymérisable suivant l'une quelconque des revendications 1 à 4, qui contient 0,01 à 10% en poids du constituant (c), sur base de la composition.

6. Composition photopolymérisable suivant l'une quelconque des revendications 1 à 5, dans laquelle la matière susceptible de polymérisation jusqu'en un état de poids moléculaire supérieur est choisie parmi les époxydes, les épisulfures et les autres éthers et thioéthers cycliques; les résines époxydes; les résines épisulfures, les éthers vinyliques, les résines phénoliques et les résines aminoplastes.

7. Composition de revêtement photopolymérisable suivant la revendication 3, dans laquelle le constituant (d) est un pigment.

8. Composition polymérisée obtenue par irradiation en lumière ultraviolette et/ou visible d'une composition suivant l'une quelconque des revendications 1 à 6.